# EUROPEAN PATENT APPLICATION

(11) **EP 0 858 250 A1**
(43) Date of publication of application: **12.08.1998**
(21) Application number: 98500015.7
(22) Date of filing: 23.01.1998
(51) Int. Cl.: H05K 1/00

(54) **Improvements introduced in printed circuit manufacturing**

(30) Priority: 05.02.1997 ES 9700225
(71) Applicant: MECANISMOS AUXILIARES INDUSTRIALES S.A. M.A.I.S.A., E-43800 Valls, Tarragona (ES)
(72) Inventor: Gomez Fernandez, Salvador, 43800 Valls (Tarragona) (ES)
(74) Representative: Morgades Manonelles, Juan Antonio

(57) **Abstract**

The printed circuit board (10) is manufactured on the basis of a flexible support (11) on which, and by conventional procedures, is adhered a coat of conductive material (12), formed by tracks (13), by the aplication by any known method of an adhesive (14) specially able to whitstand temperature, in order to avoid it's effect on the adhesive which has to whitstand strains due to folding and, in certain cases, to torsion since the conductive coat (12) to fold may be up to 800 micron thick, without the appereance of the effect named delamination, i. e. the separation of (12) and (11) due to lack of adherence between both layers.

## Description

The present application of a Patent of Invention consists as per its title in "IMPROVEMENTS INTRODUCED IN PRINTED CIRCUIT MANUFACTURING", which novel characteristics in manufacturing, shaping and design fullfill the role for which they had been specifically designed with a maximum safety and efficiency.

By printed circuit board it's understood a term that actually is considered generic applied to a method for the manufacturing of electric circuits, formed by conductors and electronic components, resistances, inductancies, capacitances and other using any of the processes of the printing art.

The printing processes most commonly employed in printed circuit board manufacturing can be divided in three great groups; material removal processes, film deposit processes and molding and embossing processes.

The support element of electronic components in most cases is a stiff non-conductive plate, on which is deposited a thin layer of conductive material in such a way that makes the interconnections needed between components.

By the patent No. 9 200 325 to same applicant is known a process for the manufacturing of a service box, and in the patent No. 9 501 610 also to same applicant is disclosed a system for integrating double printed circuits, i. e., printed in both faces, with the possibility of interconnecting two or more plates, as well as the possibility of machining a longitudinal strip of the insulating support in order to be able to fold the conductive portion and thus be able to shape several architectures that can be adapted to the service box, which in turn show an external design in agreement with the wall or surface of the vehicle to which can adapt itself.

The present application is directed to substitute the rigid substrate or insulating plate with totally flexible substrates of polyester, polyamide, FR-4, CEM-1 or other materials of same family that besides having a great flexure capacity also allow the adherence on same of a copper conductive coat, up to 800 micron, such that it can whitstand the heat produced because of the circulation of power through the conductive portion and generation of a thermal increase, and does not delaminate from said elastic and flexible support.

Anyhow, because of experiments perfomed in the laboratory, that flexibility goes toghether with a specific design of the various tracks that integrate the copper conductive layer. When these are of a configuration substantially perpendicular to the longitudinal edges of the support, the deformation strain is lesser since it does involve a very little surface of the conductive material, anyhow that does not makes more difficult the design of the circuit or tracks since a mechanical folding gives a solution to this need of a bigger strain, therefore the design of the tracks can be performed with any type of configuration, the strain of the folding being not a problem when manufacturing this type of printed circuits.

The design and manufacturing of this new type of printed circuit boards represents in the other hand another possibility of adaptation of the several components to the service boxes, since said type allows the combination with layouts in which the dielectric supports are rigid, enabling the assembly of several types of circuits (of rigid and flexible support) by the customary means, short pins, long female pins and every other element facilatating the assembly as well as the integration.

Other details and features of the present Patent of Invention will appear during the description that follows, where reference is made to the Figures attached in which there are represented the above details. These details are given as an example only, referring to a case of a practical embodiment, but are not limitative to the details explained; therefore, this description must be considered from an illustrative point of view and without any limitations whatsoever.

There follows a numbered report of the main elements included in the present invention; (10) printed circuit; (11) dielectric substrate, (12) conductive layers, (13) tracks, (14) adhesive layer, (15-15') folding line, (16) between-tracks, (17) edges.

Figure 1 is a longitudinal cross-section in elevation of a printed circuit board, manufactured as per the improvements of the present invention.

Figure 2 is a perspective view of the arrangement of conductive tracks over a FR-4, CEM-1, polyester, polyamide support, in which the orientation of the track allow the hinge effect.

Figure 3 is side view in elevation of a possible architecture of a combination of rigid support circuits (10) with flexible support (11) ones.

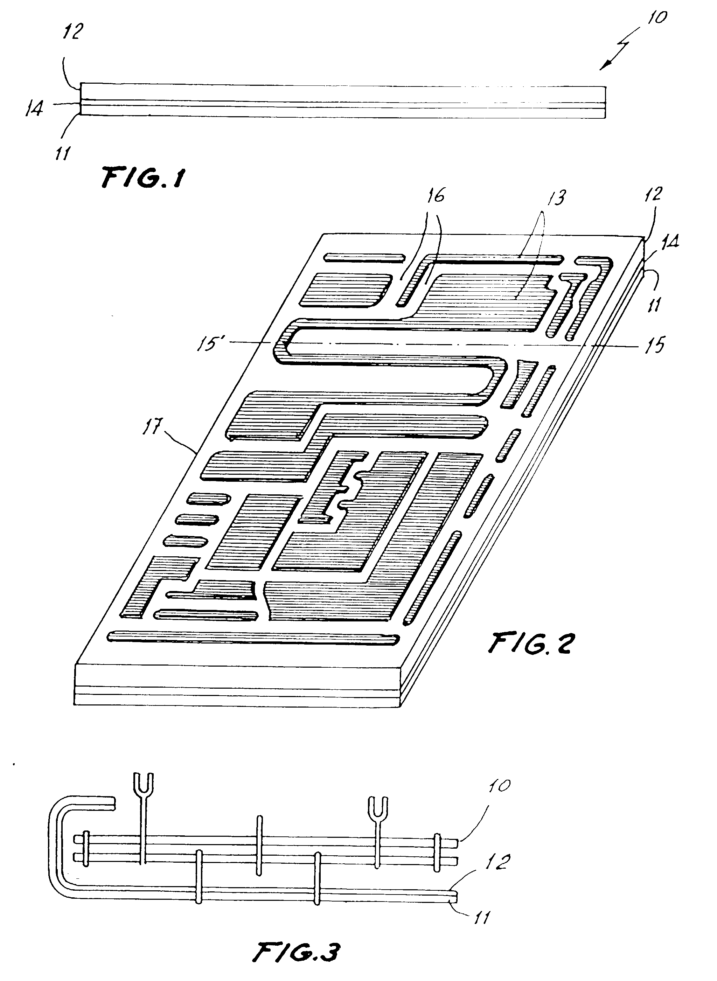

In one of the preferred embodiments of what the object of the present invention is, and as can be seen in Figure 1, the printed circuit board (10) is manufactured starting with a flexible support (11) on which, and by conventional procedures, is adhered a coat of conductive material (12), formed by tracks (13), by the application bt any known means of an adhesive (14) of special temperature resistance, in order to avoid the efect of same on the adhesive when having to support folding strains and, in some cases, to torsion being the conductive layer to fold up to 800 microns thick, without appearing the so-called delamination effect, i. e., the separation of (12) and (11) because of lack of adherence between both layers.

The configuration of the tracks (13) forming the conductive layer (12), will determine a higher or lesser effort for folding the circuit (10) when, for example, we look at the design shown in Figure 2, we appreciate that the aligning of the tracks perpendicular to the edges (17) in combination with the folding line (15-15') will determine the bigger or lesser flexibility of the whole; the void zones or between-tracks (16) in the circuit will function as a hinge allowing the folding by hand at the line (15-15'), even if the automatic folding of (10) is not excluded if the manufacturing needs make same necessary, and because of all that the design of the tracks (15) is not a problem because of the folding, but an esiness for the assembly when it's possible to design leaving folding lines in combination with the between-tracks (16).

The use of this technology in the manufacturing of the so-called service boxes such as is described in the Patent No. 9 200 325 to tha same applicant does not exclude the use of other rigid dielectric support (11) circuits. Instead it is complementary as can be seen in Figure 3, in which there is a combination of both type circuits, i. e., with flexible or rigid support without distinction, permitting a bigger number of different architectures, since the service box is to be always adapted to the needs of volume and configuration of the space designed by the vehicle manufacturer for the assembly of such a box.

Other of the added advantages of the proposed improvements is that of the lesser thickness of the selected materials for the flexible supports and with that the intensive use of same toghether with the intyegration techniques determining a lesser space occupation and a progressive miniaturization of the boxes, without hindering the combination of signal circuits with power circuits, being furthermore possible the use of the earlier disclosed combination of rigid and flexible circuits, that of the signal and power circuits with all the range of thickness of the conductive layers (12), from 35 up to 800 micron.

Enough disclosed what the present application for an invention patent in agreement with the figures attached is, it's understood that can be introduced in same any detail modifications regarded as convenient, always without departing from the essence of the present patent of invention as summarized in the following claims.

## Claims

1. "IMPROVEMENTS INTRODUCED IN PRINTED CIRCUIT MANUFACTURING" of those formed with a dielectric support, coated at one or both faces with a conductive material forming tracks and circuits integrating by suitable methods electric and electronic elements to same, with conductive layer thickness from 35 to 800 micron, characterized in that the support of dielectric flexible material will be formed with FR-4, CEM-1, polyester or polyamide or another suitable dielectric material, coated with a layer of conductive material (12) in one or both faces adhered to (11) by an adhesive able to whitstand the strains of folding of (11), since the thickness of the conductive material may be from 35 to 800 micron.

2. "IMPROVEMENTS INTRODUCED IN PRINTED CIRCUIT MANUFACTURING" characterized as per the first Claim in which the values of flexure of the printed circuit board (10) can be altered at will as per the arrangement of the tracks (15) or between-tracks (16) being perpendicular or not to the free edges of the flexible support (11).
